(19) Europäisches Patentamt
European Patent Office
Office européen des brevets

(11) **EP 3 133 714 A1**

(12) **EUROPEAN PATENT APPLICATION**

(43) Date of publication:
**22.02.2017 Bulletin 2017/08**

(51) Int Cl.:
**H02J 9/06** *(2006.01)*     **G01R 31/36** *(2006.01)*
**H02J 7/00** *(2006.01)*

(21) Application number: **16182146.7**

(22) Date of filing: **01.08.2016**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **11.08.2015 US 201514823386**

(71) Applicant: **Schneider Electric IT Corporation
West Kingston, RI 02892 (US)**

(72) Inventor: **CHAMBON, Patrick
38400 Saint Martin D'hères (FR)**

(74) Representative: **Zerbi, Guido Maria
Murgitroyd & Company
Piazza Borromeo, 12
20123 Milano (IT)**

(54) **BATTERY MONITORING METHOD AND APPARATUS**

(57) According to one aspect, embodiments herein provide an uninterruptible power supply comprising an input configured to receive input power, at least one battery having a state of charge and configured to provide battery power, an output configured to provide output power derived from at least one of the input power and the battery power, and a controller coupled to the battery and configured to generate an expected runtime for the battery based on at least a battery temperature time parameter and a state of charge time parameter.

FIG. 4

EP 3 133 714 A1

**Description**

BACKGROUND OF INVENTION

1. Field of Invention

Aspects of the present invention are in the field of battery technology and, more specifically, relate to accurately determining parameters for batteries used in power systems such as in conjunction with uninterruptable power supply (UPS) systems, or other applications that involve monitoring repetitive charge and discharge of batteries.

2. Discussion of Related Art

The use of uninterruptible power supplies to provide regulated, uninterrupted power for sensitive and/or critical loads, such as computer systems and other data processing systems, is known. A number of different UPS products are available including those available from APC® by Schneider Electric. In a typical UPS, a battery is used to provide backup power for a critical load during blackout or brownout conditions. When used in a UPS, a battery system is typically required to be periodically charged and discharged, and it is desirable to use a battery monitoring system that can accurately monitor the state of charge and runtime of the battery system.

SUMMARY OF INVENTION

Various aspects and embodiments discussed herein are directed to a battery monitoring system and apparatus, and in particular to accurately determining the state of charge and expected run time for a Li-ion battery. At least one aspect is directed to an uninterruptible power supply including an input configured to receive input power, at least one battery having a state of charge and configured to provide battery power, an output configured to provide output power derived from at least one of the input power and the battery power, and a controller coupled to the battery and configured to generate an expected runtime for the battery based on at least a battery temperature time parameter and a state of charge time parameter.

According to one embodiment, the controller is further configured to generate an available state of charge based on at least the expected runtime and the state of charge time parameter. In a further embodiment, in one mode of operation the available state of charge is less than the state of charge.

According to one embodiment, the battery temperature time parameter includes a time duration until a temperature of the battery exceeds a maximum authorized temperature threshold, and the state of charge time parameter includes a time duration until the state of charge of the battery is depleted. In one embodiment, the controller is further configured to compare the battery temperature time parameter and the state of charge time parameter and determine a lesser of the battery temperature time parameter and the state of charge time parameter. In a further embodiment, the controller is configured to determine the output power provided by the output and generate the state of charge time parameter based on the state of charge of the battery and the determined output power. In a further embodiment, the controller is configured to determine a temperature of the battery, determine battery thermal parameters, and generate the temperature time parameter based on the determined output power, determined temperature, and battery thermal parameters. In one embodiment, the battery includes a lithium ion battery.

Another aspect is directed to a method of monitoring a battery in an uninterruptible power supply having an input coupled to a power source, an output coupled to at least one load, the method including generating a battery temperature time parameter, generating a state of charge time parameter, comparing the battery temperature time parameter and the state of charge time parameter to determine a lesser of the battery temperature time parameter and the state of charge time parameter, and generating an expected runtime for the battery based on the lesser of the battery temperature time parameter and the state of charge time parameter.

According to one embodiment, the method further includes generating an available state of charge based on at least the expected runtime and the state of charge time parameter. In one embodiment, the battery has a state of charge and in one mode of operation the available state of charge is less than the state of charge. According to one embodiment, the battery temperature time parameter includes a time duration until a temperature of the battery exceeds a maximum authorized temperature threshold, and the state of charge time parameter includes a time duration until the state of charge of the battery is depleted.

In one embodiment, the method includes determining output power provided by the output, wherein generating the battery temperature time parameter includes generating the battery temperature time parameter based on the state of charge of the battery and the determined output power. According to one embodiment, the method includes determining a temperature of the battery, and determining battery thermal parameters, wherein generating the state of charge time parameter includes generating the state of charge time parameter based on the determined output power, determined temperature, and battery thermal parameters.

At least one aspect is directed to an uninterruptible power supply including an input configured to receive input power, at least one battery having a state of charge and configured to provide battery power, an output configured to provide output power derived from at least one of the input power and the battery power, and means for generating an expected runtime for the battery based on at least a battery temperature time parameter.

According to one embodiment, the uninterruptible power supply further includes means for generating an available state of charge based on at least the expected runtime and a state of charge time parameter. In one embodiment, in one mode of operation the available state of charge is less than the state of charge. According to one embodiment, the battery temperature time parameter includes a time duration until a temperature of the battery exceeds a maximum authorized temperature threshold, and the state of charge time parameter includes a time duration until the state of charge of the battery is depleted.

In one embodiment, the uninterruptible power supply includes means for comparing the battery temperature time parameter and the state of charge time parameter and determining the lesser of the battery temperature time parameter and the state of charge time parameter. According to one embodiment, the battery includes a lithium ion battery.

## BRIEF DESCRIPTION OF DRAWINGS

The accompanying drawings are not intended to be drawn to scale. In the drawings, each identical or nearly identical component that is illustrated in various figures is represented by a like numeral. For purposes of clarity, not every component may be labeled in every drawing. In the drawings:

FIG. 1 is a chart showing one example of battery charging and discharging cycles;
FIG. 2 is a block diagram of an uninterruptible power supply, according to various examples;
FIG. 3 is a flow diagram showing one example of a control process that may be implemented by the UPS system of FIG. 2;
FIG. 4 is a functional block diagram of one example of a control process that may be implemented by the UPS system of FIG. 2;
FIG. 5 is a chart showing one example of battery charging and discharging cycles, according to various examples; and
FIG. 6 is a controller that may be used with the UPS system of FIG. 2.

## DETAILED DESCRIPTION

Examples of the methods and systems discussed herein are not limited in application to the details of construction and the arrangement of components set forth in the following description or illustrated in the accompanying drawings. The methods and systems are capable of implementation in other embodiments and of being practiced or of being carried out in various ways. Examples of specific implementations are provided herein for illustrative purposes only and are not intended to be limiting. In particular, acts, components, elements and features discussed in connection with any one or more examples are not intended to be excluded from a similar role in any other examples.

Also, the phraseology and terminology used herein is for the purpose of description and should not be regarded as limiting. Any references to examples, embodiments, components, elements or acts of the systems and methods herein referred to in the singular may also embrace embodiments including a plurality, and any references in plural to any embodiment, component, element or act herein may also embrace embodiments including only a singularity. References in the singular or plural form are not intended to limit the presently disclosed systems or methods, their components, acts, or elements. The use herein of "including," "comprising," "having," "containing," "involving," and variations thereof is meant to encompass the items listed thereafter and equivalents thereof as well as additional items. References to "or" may be construed as inclusive so that any terms described using "or" may indicate any of a single, more than one, and all of the described terms. In addition, in the event of inconsistent usages of terms between this document and documents incorporated herein by reference, the term usage in the incorporated references is supplementary to that of this document; for irreconcilable inconsistencies, the term usage in this document controls.

Li-ion batteries have numerous advantageous when compared with traditional lead-acid batteries in UPS systems, including higher energy density, longer life, and wider operating temperature range. One drawback of typical Li-ion batteries systems is that they often need to be carefully monitored to prevent overheating or overcharging. In Li-ion batteries, the temperature of the batteries increases drastically during the battery discharge process and slowly during the battery charging process. This makes successive discharge/charge cycles difficult to perform without exceeding a maximum authorized battery temperature. Conventional systems for controlling battery status include a Battery Monitoring System (BMS) that tracks battery parameters, such as voltage, current, and power, and estimates a state of charge and runtime. State of charge refers to the current amount of energy available from the battery compared to the available amount when the battery is fully charged. State of charge is expressed as a percentage (0% = no available charge and 100% = fully charged). Runtime refers to the length of time for which the battery can supply battery power.

While systems and methods for determining a state of charge and runtime of a battery system exist, challenges still exist in providing accurate available state of charge and expected runtime of a Li-ion battery. For example, conventional methods of monitoring battery status typically neglect the impact of temperature on battery operation. Failure to address temperature changes may result in many situations where a battery is unable to deliver the full amount of energy estimated by the state of charge, or reach the full estimated runtime. For example, following successive charge and discharge cycles in a UPS, during a subsequent discharge, a battery may exceed a maximum authorized temperature before the state of charge has reached 0%. Upon reaching the maximum temperature, the battery discharge may be stopped, prior to final discharge of the battery, possibly resulting in the battery monitoring system of the UPS providing a user with an available run time greater than is actually available. The battery discharge may be stopped by the UPS upon detection of an over temperature detection or failure of the battery as a result of the high temperature condition. In either case, the UPS may stop power delivery to connected loads prior to the end of a runtime provided to the connected loads, possibly resulting in loss of data.

The battery status reported by the BMS to the operator of the UPS is also often incorrect. For instance, despite recovering some capacity during a recharge process, this available charge may be incorrectly displayed as available to the user because the battery may have exceeded, or be dangerously close to exceeding, a maximum authorized temperature. Such situations arise even more frequently with the development of fast-charging Li-ion battery chargers, limiting the opportunity of the battery to cool down from temperature increases.

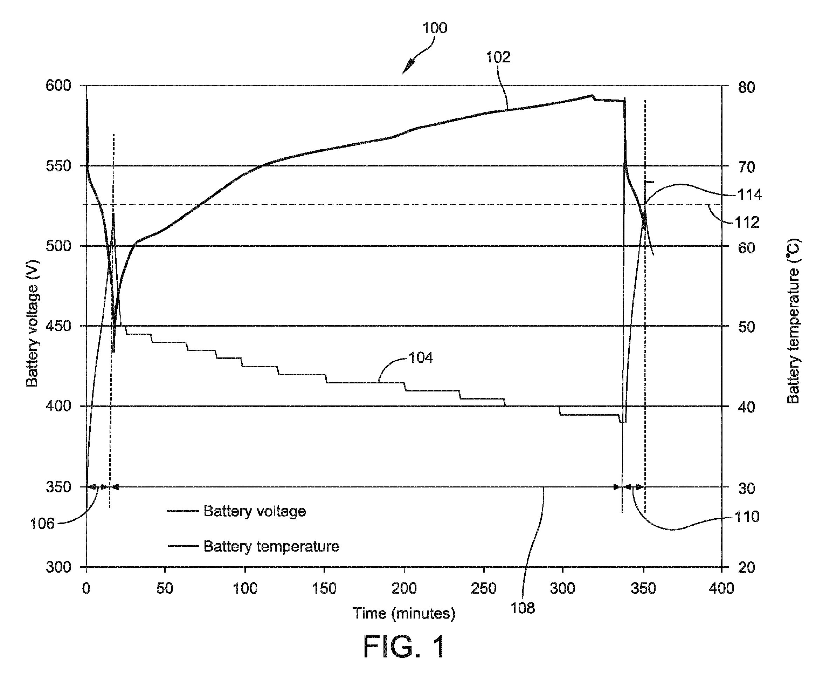

Referring to FIG. 1, there is illustrated a chart showing voltage and temperature as a function of time during successive charge and discharge cycles for a conventional BMS controlled UPS system battery. For example, the battery may include a 125kW Li-ion battery. In the illustrated example, trace 102 represents the voltage of the battery and trace 104 represents the temperature of the battery. FIG. 1 shows a first discharge cycle 106, a first charge cycle 108, and a second discharge cycle 110. During the first discharge cycle 106, the voltage across terminals of the battery drops. At the end of the first discharge cycle 106, the battery enters the first charging cycle 108 in which the voltage across the terminals of the battery steadily increases. The first charge cycle 108 is interrupted by the second discharge cycle 110, at which the voltage across the terminals of the battery again drops.

In the illustrated chart 100 of FIG. 1, a maximum authorized temperature of the battery is represented by line 112 (e.g., shown as approximately 65° C). As discussed above, some of the problems associated with conventional battery monitoring methods arise due to neglect of the temperature of the battery (e.g., a cell temperature) until a maximum authorized temperature has been exceeded.

As illustrated in FIG. 1, the temperature of the battery rapidly increases during the first discharge cycle 106 of the battery. FIG. 1 shows the temperature increasing from approximately 27° C to approximately 64° C during the first discharge cycle 106. The first discharge cycle 106 is shown as occurring during a time span of approximately 17 minutes at a discharge power of 100kW. At the end of the first discharge cycle 106, the battery slowly begins to cool. During the first charge cycle 108 the battery temperature is shown as decreasing to approximately 38° C over a span of 5 hours. The battery temperature again spikes when the first charge cycle 108 is interrupted by the second discharge cycle 110. Despite having charge available during the second discharge cycle 110, the battery temperature exceeds the maximum authorized temperature before the battery is entirely discharged. For example, despite having approximately 18 minutes of charge available, a temperature fault occurs after 12 minutes of discharge at a position labeled 114. As the battery still had available charge prior to the temperature fault, in such situations, warnings or alarms that would otherwise prevent a dropped load, will not be transmitted.

Aspects and embodiments described herein provide a method and apparatus for monitoring the status of a battery that incorporates the thermal condition of the battery, preventing unexpected dropped load conditions and potential damage to coupled equipment and/or loss of data.

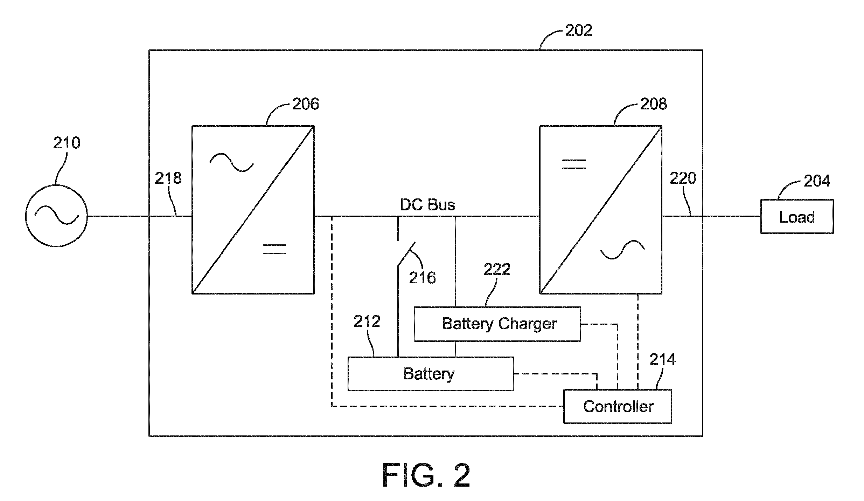

Referring to FIG. 2, there is illustrated a block diagram of one example of a UPS according to various aspects and embodiments. The UPS 202 provides regulated power to a load 204 from either an AC power source 210 (e.g., AC mains) or a back-up power source, such as a battery 212. While shown in FIG. 2 as including a single battery, in various embodiments the battery 212 may include an array of batteries. The UPS 202 includes an AC-DC converter 206, a DC-AC converter 208, a relay 216, a battery charger 222, and a controller 214 for controlling the AC-DC converter 206, the DC-AC converter 208, the relay 216, the battery 212, and the battery charger 222. The UPS 202 has an input 218 coupled to the AC power source 210 and an output 220 coupled to the load 204.

During line mode of operation and under control of the controller 214, the AC-DC converter 206 converts the input AC voltage into a DC voltage at the DC bus. For example, the DC bus may be rated up +/-500 VDC. In backup mode of operation (optionally called battery mode of operation), upon loss of input AC power, the relay 216 is activated and the UPS 202 generates a DC voltage from the battery 212. The length of time for which the battery 212 can supply the DC voltage is referred to as the "runtime" of the battery 212. The battery charger 222 is used to recharge the battery 212 and may be controlled by the controller 100. In various embodiments the battery 212 may be charged during line mode of operation. In line mode, the DC-AC converter 208 receives the DC voltage from the AC-DC converter 206, whereas, during backup mode of operation the DC-AC converter 208 receives a DC voltage from the battery 212. The DC-AC converter 208 converts the DC voltage into an output AC voltage and delivers the AC output to the load 204. In various embodiments, the relay 216 is controlled by the controller 214, for example, to alternate between line mode and backup mode of operation. As discussed herein, in various embodiments the battery 212 may include a Li-ion battery.

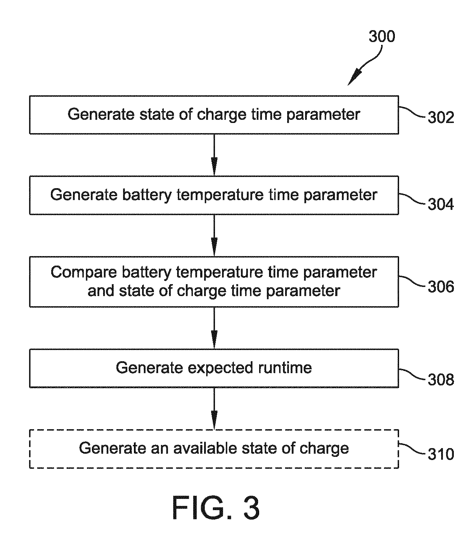

Referring to FIG. 3, there is illustrated a flow diagram showing one example of a control process that may be implemented by the UPS system of FIG. 2 to monitor available charge at the battery 212. For example, the process 300 may be implemented by the controller 214 of the UPS 200 shown in FIG. 2. The process may be used to determine and provide an expected runtime and/or available state or charge that keeps the battery at a maximum state of charge and runtime without exceeding the maximum authorized temperature of the battery. The process 300 includes acts of generating a battery temperature time parameter, generating a state of charge time parameter, comparing the battery temperature time parameter and the state of charge time parameter, and generating an expected runtime. The process may also include the act of generating an available state of charge.

In act 302 the controller may receive one or more battery measurements or parameters and generate a state of charge time parameter. The measurements may be made using one or more sensors coupled to the battery and/or contained within a system housing of one or more batteries. As used herein, the state of charge time parameter includes a duration at a known power draw from the battery for which the battery may deliver charge before the battery is depleted of charge. In various embodiments, act 302 is performed responsive to determining a state of charge of the battery based on received battery measurements, parameters of the battery, the condition of the battery, and the power draw from the battery. The parameters and the condition of the battery may be determined by the controller or retrieved from a data store, such as a table of battery parameters stored and indexed at a data store of the controller. Responsive to generating the state of charge of the battery, the controller may receive or determine the power being drawn from the battery to generate the state of charge time parameter. For example, a discharge cycle of a 125kW Li-ion battery may be performed at 100kW.

In act 304 the controller may receive one or more battery measurements or thermal parameters and generate a battery temperature time parameter. As used herein, the battery temperature time parameter includes the duration for which the battery may deliver charge before exceeding the authorized maximum temperature of the battery. For example, a 125kW Li-ion battery may have a maximum authorized temperature rating of 65° C. In various embodiments, the controller uses a first order model of battery temperature behavior to generate the battery temperature time parameter. For example, the battery temperature time parameter may be generated according to:

$$\Delta T(t) = k e^{\frac{t}{\tau}}$$

,

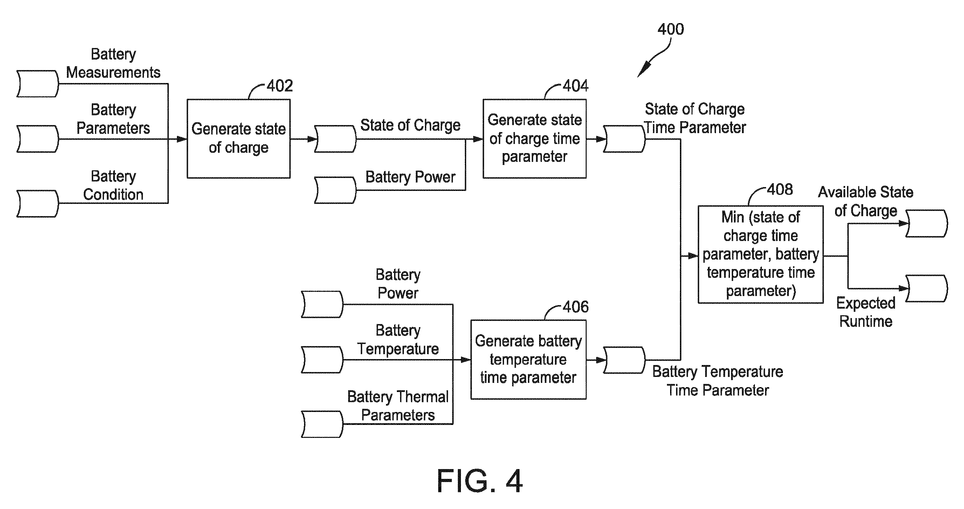

in which $\Delta T(t)$ includes the temperature difference between an ambient temperature and the battery temperature as a function of time during a discharge cycle, k includes the maximum temperature difference between the ambient temperature and the battery temperature (i.e., the steady state temperature difference for a permanent discharge cycle), and $\tau$ includes the battery thermal time constant (at $\tau$ 63% of the maximum temperature difference will be reached). Each parameter may be a constant value, or extracted from lookup table, for example, which lists the values of the parameters as a function of the battery discharge power. While in various embodiments the controller may use a first order model of battery temperature behavior to generate the battery temperature time parameter, in various embodiments other models may be used and are further described below with reference to FIG. 4.

According to various embodiments, responsive to generating the battery temperature time parameter and the state of charge time parameter, the controller may compare each of these parameters and generate an expected runtime of the battery (acts 306 and 308). In various embodiments, generating an expected runtime of the battery includes determining the lesser of the battery temperature time parameter and the state of charge time parameter. In determining the lesser parameter, the controller ensures that the battery will discharge the entire stored charge before the battery temperature exceeds the authorized maximum, and if the battery will exceed the authorized maximum, that only the amount capable of being discharged without exceeding that maximum is considered. Such embodiments provide for a more accurate determination of battery runtime that will avoid any unexpected temperature faults, dropped load conditions, or lost data.

In further embodiments, the controller may generate the available state of charge based on the expected runtime (act 310). It is appreciated that in various embodiments, the available state of charge may be equal to the state of charge. However, in one mode of operation (e.g., when the battery has successively performed charge and discharge cycles), the available state of charge may be less than the state of charge. For example, the available state of charge may be generated according to:

$$Available\ SOC = \min(SOC \times \frac{expected\ runtime}{state\ of\ charge\ time\ parameter}, SOC)$$

,

in which SOC is the state of charge. In various embodiments, the controller replaces the state of charge with the available state of charge. For example, the controller may halt a discharge cycle when the battery has reached a 0 value of the available state of charge, despite the state of charge indicating a non-0 number. As described above, this prevents the battery from discharging beyond a maximum authorized battery temperature.

While not shown in FIG. 3, in various embodiments the controller may display or provide to a user or operator of the UPS the generated expected runtime or available state of charge of the battery. These generations may be displayed, for example, at a user interface of the UPS or at a control station. The controller may also generate one or more alerts or warnings regarding the state or condition of the battery relative to the generated expected runtime or available state of charge. In one embodiment, the controller is configured to generate and/or provide a low battery warning when the expected runtime of the battery reaches a predetermined minimum threshold. For example, the battery may compare the expected runtime to the predetermined threshold and generate a warning if the expected runtime is equal to or less than the predetermined threshold. Similarly, the controller may generate an alert and provide a command to equipment coupled with the UPS if the expected runtime is equal to or less than the predetermined threshold. In many instances, such a situation will indicate that the temperature of the battery is approaching the maximum authorized temperature. Accordingly, the controller may command the UPS or coupled equipment to take damage preventative measures, such as halting operation of the coupled equipment, or the UPS.

Referring now to FIG. 4, with continuing reference to FIG. 2, there is illustrated a functional block diagram of one example of a control process that may be implemented by the UPS 200 of FIG. 2 to monitor the charge delivered by the battery 212. As discussed above with reference to FIG. 3, in various embodiments a process of monitoring a battery may include: generating a state of charge (block 402); generating a state of charge time parameter (block 404), generating a battery temperature time parameter (block 406), and comparing the state of charge time parameter and battery temperature time parameter to determine the lesser (i.e., minimum) of the state of charge time parameter and battery temperature time parameter (block 408).

In various embodiments, the controller executes one or more state of charge algorithms or processes to generate a state of charge of the battery. For example, the controller may indirectly generate the state of charge of the battery by direct measurement of system parameters, such as battery measurements, battery parameters, and battery conditions. Battery measurements may include current, voltage, or temperature, battery parameters may include the battery type, number of cells, and capacity, and the battery condition may include the age or state of health of the battery. State of charge may be generated according to current integration, Kalman filtering, voltage-based algorithms, or one or more combined approaches. While various algorithms may be used, in one example, the controller when operating executes a series of instructions according to:

$$S = 1 - \frac{Q}{C_{10}}$$

,

in which, Q includes the quantity of charge and $C_{10}$ includes the battery capacity (e.g., manufacturer provided battery capacity from a manufacturer datasheet). Quantity of charge may be determined according to the following recurrent instructions:

$$Q(n) = Q(n-1) + I_{bat} * T_s$$

,

in which Q(n-1) includes the quantity of charge at a previous sampling time, $I_{bat}$ includes the measured battery current, and $T_s$ includes the sampling time.

Responsive to generating the state of charge, the controller is configured to generate the state of charge time parameter. As discussed above, the state of charge time parameter includes the time until the battery is completely depleted. In various embodiments, the controller may directly or indirectly measure the power discharged by the battery using one or more voltage and current sensors. Once determined, the controller is configured to execute a series of instructions employing the determined battery power and state of charge to generate the state of charge time parameter.

While various algorithms may be used, in one example, the controller executes a series of instructions to index a lookup table of several runtime estimations. For example, the lookup table may include a two dimension lookup table (LT) having two input parameters, state of charge (SOC) and discharge power (P). Accordingly, the state of charge time parameter may be generated according to LT(SOC, P), in which the state of charge ranges from 0% to 100%. In various implementations, the lookup table may include a plurality of estimated run time calculations based on experimental results. In further embodiments, the controller may determine the state of charge time parameter based on any appropriate algorithm.

In various embodiments, in parallel with generating the state of charge time parameter, the controller is configured to generate the battery temperature time parameter. As described above, the battery temperature time parameter includes the time until a maximum authorized battery temperature is reached. The controller may directly or indirectly measure one or more parameters to generate the battery temperature time parameter. In one embodiment, the controller determines battery power, battery temperature, and battery thermal parameters. For example, battery temperature may include cell temperature. In one embodiment, thermal parameters may include constant data associated with the battery that is based on a particular thermal model. For example, as discussed above, in one embodiment the thermal parameters may include k and $\tau$. Once measured, the controller is configured to execute a series of instructions employing the determined battery power, battery temperature, and battery thermal parameters to generate the battery temperature time parameter. As discussed above, in one embodiment the controller may execute a series of instructions that performs a first order model of battery behavior. However, in various other embodiments the controller may execute a series of instructions according to a custom model provided by the battery manufacturer, reference a lookup table based on the battery power and the temperature difference between the battery and an ambient temperature, or execute an autoadaptive algorithm which identifies the k and $\tau$ parameters previously determined during a first battery discharge cycle.

If the thermal model of the battery is written as a function, $T_{bat} = f(t)$, the function may be inverted, $t = f^1(T_{bat})$, such that the battery temperature time parameter may be generated (i.e., $t = f^1(T_{batmax})$). However, in an implementation where the controller is instructed to reference a lookup table, the battery temperature time parameter is provided automatically responsive to generation of the index and reference to the lookup table. In some instances, it may be necessary for the controller to interpolate a value between two lookup table values.

Responsive to generating the state of charge time parameter or battery temperature time parameter, whether in parallel or sequentially, the controller is configured to generate the expected runtime of the battery. Accordingly, various embodiments permit prevention of unexpected dropped load conditions and permit accurate and timely alerts and warnings. In one embodiment, the controller is configured to execute a series of instructions that determine the lesser value of a data set including the state of charge time parameter and the battery temperature time parameter. In such an embodiment, the controller determines whether the battery will deplete the stored charge before exceeding a maximum authorized temperature. If the maximum authorized temperature will not be exceeded, the state of charge time parameter is provided as the expected runtime of the battery. However, if the maximum authorized temperature will be exceeded before the battery is depleted of all charge, the battery temperature time parameter is provided as the expected runtime of the battery (e.g., the time until the maximum temperature threshold will be exceeded).

In further embodiments, responsive to generating the expected runtime of the battery, the controller may be further configured to generate the available state of charge. As discussed above, the available state of charge includes the state of charge adjusted to prevent the battery from exceeding the maximum authorized temperature of the battery. Various processes for determining the available state of charge are discussed above with reference to FIG. 3.

While described above in the context of discrete values, in various embodiments the state of charge time parameter or battery temperature time parameter may consist of a series of values, or string of values. In further embodiments, the controller may also be configured to continually generate a series of state of charge time parameters or battery temperature time parameters. Accordingly, it is appreciated that various embodiments may continually monitor in real-time, and provide timely and accurate generations of the available state of charge and the expected runtime of the battery.

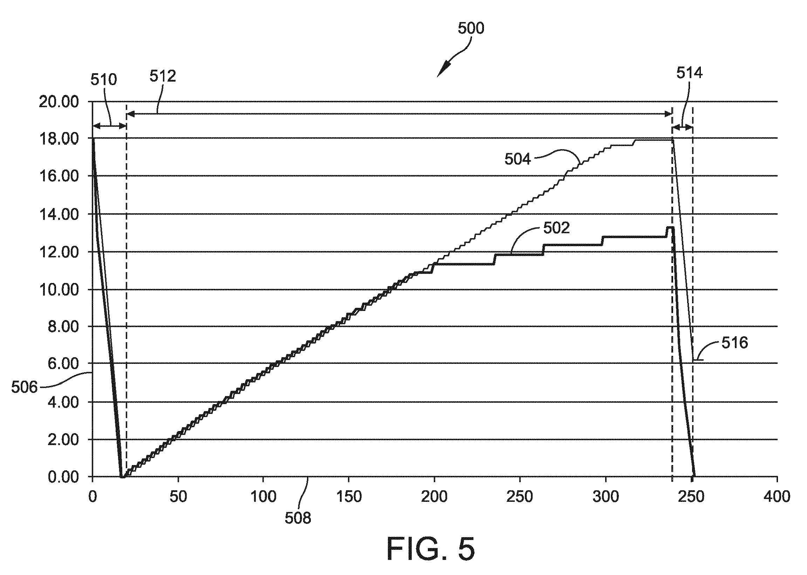

Referring now to FIG. 5, there is illustrated a chart 500 showing one example of battery charging and discharging cycles, according to various embodiments. For example, the battery may include a Li-ion 125kW battery. The vertical axis 506 shows runtime in minutes and the horizontal axis 508 shows time in minutes. A first trace 502 represents charge and discharge cycles of a battery managed according to various aspects and embodiments discussed herein, and a second trace 504 represents charge and discharge cycles of a battery managed by a conventional BMS.

In the illustrated example, at the beginning of the first discharge cycle 510, the runtime indicated by the first trace 502 and the second trace 504 is approximately 18 min. As discussed above, this conveys to a user or operator that it will take approximately 18 minutes to fully discharge the battery at the present level of power draw from the battery. At the end of the first discharge cycle 510, batteries of the compared systems enter a charging cycle 512 wherein the runtime for each battery slowly increases as the battery is charged. As described above, problems in operation of a UPS may arise if the battery is not adequately cooled during the recharge process. Issues can arise because Li-ion batteries drastically increase in temperature during a discharge cycle, and slowly decrease in temperature during a charging cycle. As shown, the conventional BMS fails to account for the uneven temperature changes and, accordingly, does not provide an accurate runtime. FIG. 5 shows the second trace 504 as increasing to a maximum runtime at a steady rate, despite any temperature constraints of the battery and associated UPS. In contrast, the first trace 502 shows the runtime stabilizing to an expected runtime to account for the thermal constraints of the battery and associated UPS.

As illustrated in FIG. 5, when a second discharge cycle 514 begins, the conventional BMS still shows that approximately 6 minutes of runtime are remaining when an unexpected temperature fault occurs at the position labeled 516. In contrast, aspects and embodiments discussed herein accurately determine the maximum expected runtime of the battery to provide the maximum duration of charge without exceeding thermal constraints of the battery and creating an unexpected fault. Accordingly, trace 502 shows 0 runtime remaining at the moment before the maximum temperature threshold is reached.

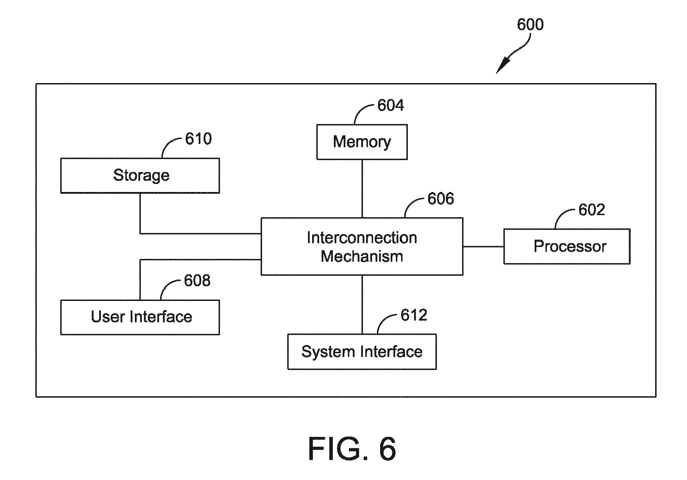

Referring to FIG. 6, there is illustrated a block diagram of a controller 600, in which various aspects and functions are practiced. FIG. 6 is described with reference to the UPS 200 illustrated in FIG. 2. For example, the controller 600 may include the controller 214 shown in FIG. 2. As shown, the controller 600 can include one or more systems components that exchange information. More specifically, the controller 600 can include at least one processor 602, a power source (not shown), a data storage 610, a system interface 612, a user interface 608, a memory 604, and one or more interconnection mechanisms 606. The controller 600 may also include a power source (not shown) that provides electrical power to other components. The at least one processor 602 may be any type of processor or multiprocessor. The at least one processor 602 is connected to the other system components, including one or more memory devices 604 by the interconnection mechanism 606. The system interface 612 couples one or more sensors or UPS components (e.g., AC-DC converter 206, DC-AC converter 208, or battery 212) to the at least one processor 602.

The memory 604 stores programs (e.g., sequences of instructions coded to be executable by the processor 602) and data during operation of the controller 600. Thus, the memory 604 may be a relatively high performance, volatile, random access memory such as a dynamic random access memory ("DRAM") or static memory ("SRAM"). However, the memory 604 may include any device for storing data, such as a disk drive or other nonvolatile storage device. Various examples may organize the memory 604 into particularized and, in some cases, unique structures to perform the functions disclosed herein. These data structures may be sized and organized to store values for particular data and types of data.

Components of the controller 600 are coupled by an interconnection mechanism such as the interconnection mechanism 606. The interconnection mechanism 606 may include any communication coupling between system components such as one or more physical busses in conformance with specialized or standard computing bus technologies such as IDE, SCSI, PCI and InfiniBand. The interconnection mechanism 606 enables communications, including instructions and data, to be exchanged between system components of the controller 600.

The controller 600 can also include one or more user interface devices 608 such as input devices, output devices and combination input/output devices. Interface devices may receive input or provide output. More particularly, output devices may render information for external presentation. Input devices may accept information from external sources. Examples of interface devices include keyboards, mouse devices, trackballs, microphones, touch screens, printing devices, display screens, speakers, network interface cards, etc. Interface devices allow the controller 600 to exchange information and to communicate with external entities, such as users and other systems.

The data storage element 610 includes a computer readable and writeable data storage medium configured to store noon-transitory instructions and other data, and cant include both nonvolatile storage media, such as optical or magnetic disk, ROM or flash memory, as well as volatile memory, such as RAM. The instructions may include executable programs or other code that can be executed by the at least one processor 602 to perform any of the functions described here below.

Although not illustrated in FIG. 6, the controller 600 may include additional components and/or interfaces, such as a communication network interface (wired and/or wireless), and the at least one processor 602 may include a power saving processor arrangement. In various embodiments, the controller 600 may include a digital signal processor.

In at least some embodiments described above, a power system having an improved monitoring system is described. While primarily described in the context of a single phase system, in other embodiments the power system may include a multi-phase system, such as a three phase system. Furthermore, various embodiments may include any combination of inputs and outputs while only discussed and shown herein as including a single input and single output. In other embodiments, various aspects and embodiments discussed herein may be used in other types of UPSs and in other types of devices that include Li-ion batteries. For example, aspects and embodiments may include methods for monitoring battery parameters in an on-line UPS, off-line UPS, or line-interactive UPS. Further, aspects and embodiments may include methods for monitoring battery parameters in mobile devices, power tools, electric vehicles, and telecommunication equipment. Aspects and embodiments discussed herein may include means for performing any of the functions discussed herein.

Various aspects and functions described herein in accord with the present disclosure may be implemented as hardware, software, firmware or any combination thereof. Aspects in accord with the present disclosure may be implemented within methods, acts, systems, system elements and components using a variety of hardware, software or firmware configurations. Furthermore, aspects in accord with the present disclosure may be implemented as specially programmed hardware and/or software.

Having thus described several aspects of at least one embodiment of this invention, it is to be appreciated various alterations, modifications, and improvements will readily occur to those skilled in the art. Such alterations, modifications, and improvements are intended to be part of this disclosure, and are intended to be within the spirit and scope of the invention. Accordingly, the foregoing description and drawings are by way of example only.

**Claims**

1. An uninterruptible power supply comprising:

   an input configured to receive input power;
   at least one battery having a state of charge and configured to provide battery power;
   an output configured to provide output power derived from at least one of the input power and the battery power; and
   a controller coupled to the battery and configured to generate an expected runtime for the battery based on at least a battery temperature time parameter and a state of charge time parameter.

2. The uninterruptible power supply of claim 1, wherein the controller is further configured to generate an available state of charge based on at least the expected runtime and the state of charge time parameter.

3. The uninterruptible power supply of claim 2, wherein in one mode of operation the available state of charge is less than the state of charge.

4. The uninterruptible power supply of claim 1, wherein the battery temperature time parameter includes a time duration until a temperature of the battery exceeds a maximum authorized temperature threshold, and the state of charge time parameter includes a time duration until the state of charge of the battery is depleted.

5. The uninterruptible power supply of claim 4, wherein the controller is further configured to compare the battery temperature time parameter and the state of charge time parameter and determine a lesser of the battery temperature time parameter and the state of charge time parameter.

6. The uninterruptible power supply of claim 5, wherein the controller is configured to determine the output power provided by the output and generate the state of charge time parameter based on the state of charge of the battery and the determined output power.

7. The uninterruptible power supply of claim 6, wherein the controller is configured to determine a temperature of the battery, determine battery thermal parameters, and generate the temperature time parameter based on the determined output power, determined temperature, and battery thermal parameters.

8. The uninterruptible power supply of claim 1, wherein the battery includes a lithium ion battery.

9. A method of monitoring a battery in an uninterruptible power supply having an input coupled to a power source, an output coupled to at least one load, the method comprising:

   generating a battery temperature time parameter;
   generating a state of charge time parameter;
   comparing the battery temperature time parameter and the state of charge time parameter to determine a lesser of the battery temperature time parameter and the state of charge time parameter; and
   generating an expected runtime for the battery based on the lesser of the battery temperature time parameter and the state of charge time parameter.

10. The method of claim 9, further comprising generating an available state of charge based on at least the expected runtime and the state of charge time parameter.

11. The method of claim 10, wherein the battery has a state of charge and in one mode of operation the available state of charge is less than the state of charge.

12. The method of claim 9, wherein the battery temperature time parameter includes a time duration until a temperature of the battery exceeds a maximum authorized temperature threshold, and the state of charge time parameter includes a time duration until the state of charge of the battery is depleted.

13. The method of claim 9, further comprising determining output power provided by the output, wherein generating the battery temperature time parameter includes generating the battery temperature time parameter based on the state of charge of the battery and the determined output power.

14. The method of claim 13, further comprising:

   determining a temperature of the battery; and
   determining battery thermal parameters,

   wherein generating the state of charge time parameter includes generating the state of charge time parameter based on the determined output power, determined temperature, and battery thermal parameters.

15. An uninterruptible power supply comprising:

   an input configured to receive input power;
   at least one battery having a state of charge and configured to provide battery power;
   an output configured to provide output power derived from at least one of the input power and the battery power; and
   means for generating an expected runtime for the battery based on at least a battery temperature time parameter.

FIG. 1

FIG. 2

EP 3 133 714 A1

300

| Generate state of charge time parameter | 302 |

↓

| Generate battery temperature time parameter | 304 |

↓

| Compare battery temperature time parameter and state of charge time parameter | 306 |

↓

| Generate expected runtime | 308 |

↓

| Generate an available state of charge | 310 |

FIG. 3

FIG. 4

FIG. 5

FIG. 6

## EUROPEAN SEARCH REPORT

Application Number

EP 16 18 2146

Europäisches
Patentamt
European
Patent Office
Office européen
des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2001/033502 A1 (BLAIR CHARLES F [US] ET AL) 25 October 2001 (2001-10-25) * abstract; figures 2,3 * * paragraphs [0018] - [0030], [0079] - [0088] * | 1,5,8,9, 15 | INV. H02J9/06 G01R31/36 H02J7/00 |
| A | WO 2015/106986 A1 (FRESENIUS VIAL SAS [FR]) 23 July 2015 (2015-07-23) * abstract * * page 5, line 11 - page 12, line 26 * | 1-15 | |
| A | US 2004/157113 A1 (KLANG JAMES K [US]) 12 August 2004 (2004-08-12) * abstract * * paragraphs [0005], [0018] - [0055]; figures 2,3 * | 1-15 | |
| A | WO 2014/105009 A1 (SCHNEIDER ELECTRIC IT CORP [US]) 3 July 2014 (2014-07-03) * abstract * * page 6, line 9 - page 13, line 31 * | 1-15 | TECHNICAL FIELDS SEARCHED (IPC) |
| A | WO 97/15839 A1 (GLOBE UNION INC [US]) 1 May 1997 (1997-05-01) * the whole document * | 1-15 | H02J G01R |

The present search report has been drawn up for all claims

| Place of search | Date of completion of the search | Examiner |
|---|---|---|
| Munich | 13 January 2017 | Lorenzo Feijoo, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 18 2146

This annex lists the patent family members relating to the patent documents cited in the above-mentioned European search report.
The members are as contained in the European Patent Office EDP file on
The European Patent Office is in no way liable for these particulars which are merely given for the purpose of information.

13-01-2017

| Patent document cited in search report | | Publication date | Patent family member(s) | | | Publication date |
|---|---|---|---|---|---|---|
| US 2001033502 | A1 | 25-10-2001 | AU | 4155901 | A | 27-08-2001 |
| | | | EP | 1258070 | A2 | 20-11-2002 |
| | | | US | 2001033502 | A1 | 25-10-2001 |
| | | | US | 2004160214 | A1 | 19-08-2004 |
| | | | WO | 0161822 | A2 | 23-08-2001 |
| WO 2015106986 | A1 | 23-07-2015 | CN | 105814446 | A | 27-07-2016 |
| | | | EP | 3094983 | A1 | 23-11-2016 |
| | | | US | 2016299196 | A1 | 13-10-2016 |
| | | | WO | 2015106986 | A1 | 23-07-2015 |
| US 2004157113 | A1 | 12-08-2004 | DE | 10394007 | T5 | 02-02-2006 |
| | | | US | 2004157113 | A1 | 12-08-2004 |
| | | | US | 2007090844 | A1 | 26-04-2007 |
| | | | WO | 2004062010 | A1 | 22-07-2004 |
| WO 2014105009 | A1 | 03-07-2014 | CN | 105009399 | A | 28-10-2015 |
| | | | EP | 2939320 | A1 | 04-11-2015 |
| | | | US | 2015333554 | A1 | 19-11-2015 |
| | | | WO | 2014105009 | A1 | 03-07-2014 |
| WO 9715839 | A1 | 01-05-1997 | AU | 7459096 | A | 15-05-1997 |
| | | | WO | 9715839 | A1 | 01-05-1997 |

EPO FORM P0459

For more details about this annex : see Official Journal of the European Patent Office, No. 12/82